# DEMANDE DE BREVET EUROPEEN

(11) **EP 2 618 370 A1**
(43) Date de publication de la demande: **24.07.2013**
(21) Numéro de dépôt: 13150975.4
(22) Date de dépôt: 11.01.2013
(51) Int. Cl.: H01L 23/045, H01L 23/055, H01L 23/492, H01L 31/0203, H01L 23/047

(54) **Procédé pour la réalisation de traversées électriques étanches au travers d'un boitier d'encapsulation et boitier d'encapsulation muni d'au moins l'une de ces traversées électriques**

(30) Priorité: 17.01.2012 FR 1200144
(71) Demandeur: SOCIETE FRANCAISE DE DETECTEURS, INFRAROUGES- SOFRADIR, F-92290 Chatenay Malabry (FR)
(72) Inventeur: Colbeau, François, 38113 Veurey Voroize (FR)
(74) Mandataire: Vuillermoz, Bruno

(57) **Abrégé**

Ce procédé pour la réalisation de traversées électriques étanches au travers d'un boîtier d'encapsulation, notamment pour un composant électronique, optique ou optoélectronique, consiste :
- à ménager un orifice traversant (31) au sein de l'une des parois du boîtier, et avantageusement le fond (20) dudit boîtier ; et
- à braser sur cet orifice, une plaque (30) réalisée en céramique cofrittée au sein de laquelle transitent les connexions électriques.

## Description

### DOMAINE DE L'INVENTION

La présente invention s'inscrit dans le domaine des boîtiers d'encapsulation étanches, et plus particulièrement dans celui des détecteurs, notamment de rayonnements électromagnétiques, et plus particulièrement de rayonnements infrarouges refroidis.

### ARRIERE-PLAN TECHNOLOGIQUE

Dans le domaine de la détection infrarouge fonctionnant à basse température, c'est-à-dire mettant en oeuvre les phénomènes quantiques, le détecteur doit être refroidi à des températures très basses, typiquement comprises entre 50 et 200 K.

A cet effet, un tel détecteur est traditionnellement associé à une enceinte cryostatique également appelée cryostat, permettant, en fonction de la température d'utilisation du détecteur, de refroidir ce dernier par l'intermédiaire d'un doigt froid, alimenté soit par de l'hélium liquide, soit par de l'air liquide, voire même par de l'azote liquide ou encore par un dispositif cryogénérateur.

En outre, le détecteur lui-même est généralement encapsulé dans un boîtier étanche, au sein duquel règne le vide.

Parmi les différentes difficultés que l'on rencontre avec ce type de détecteurs, figure la problématique née de la connectique électrique, c'est-à-dire de l'acheminement des signaux électriques générés par le détecteur à l'extérieur du boitier étanche qui le contient, afin de permettre leur traitement.

En effet, le plus souvent, ces éléments de connectique doivent traverser le boitier sans affecter l'étanchéité de ce dernier, afin de préserver le vide qui y règne.

De fait, et à ce jour, différentes technologies sont mises en oeuvre pour assurer cette traversée de la connectique.

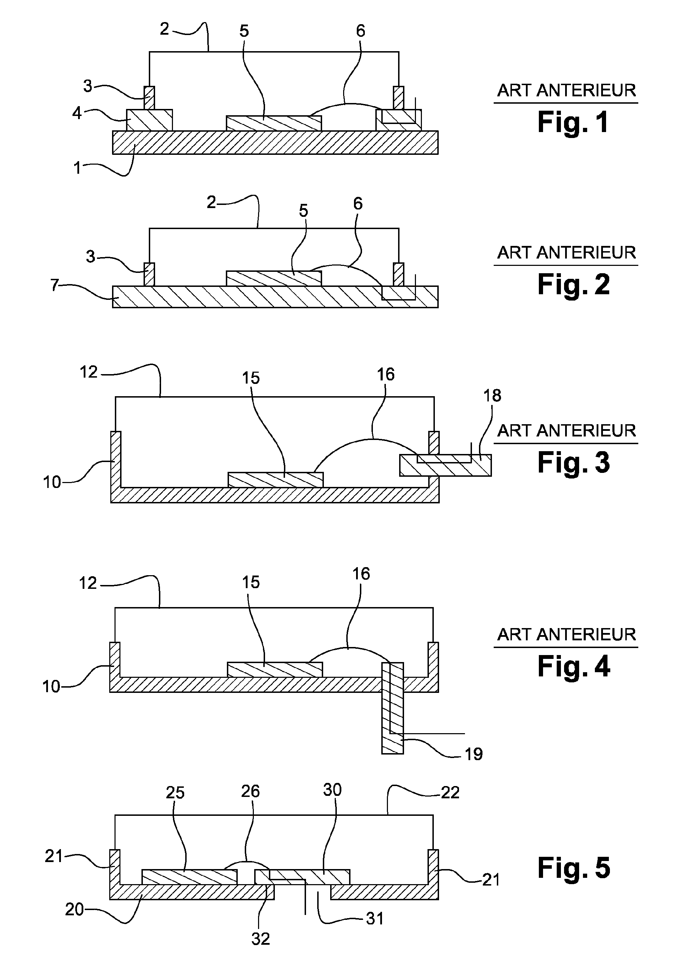

Parmi celles-ci-ci, figure tout d'abord la technologie dite de la céramique cofrittée. Au sein de cette technique, on distingue deux formes de réalisation, respectivement illustrées par les figures 1 et 2, représentant toutes deux des vues schématiques en section d'un boîtier d'encapsulation d'un composant.

Dans la première forme de réalisation, le boîtier est défini par une embase **1,** réalisée en alliage FeCoNi, typiquement en Kovar^{®}, en raison de son faible coefficient de dilatation thermique. L'embase **1** reçoit en outre un cadre périphérique **4,** réalisé en céramique cofrittée HTCC (pour l'acronyme anglo-saxon « *High Temperature Cofired Ceramic* », ou céramique cofrittée à haute température), ainsi qu'un cadre périphérique **3,** réalisé e, n Kovar^{®}. L'embase **1,** le cadre périphérique **4** et la cadre périphérique **3** sont brasés ensemble. Ensuite, on rapporte sur l'ensemble ainsi constitué par soudure laser un capot ou cadre de fermeture **2** du boitier.

Au sein du boitier ainsi défini, un composant **5** est fixé avant fermeture par collage ou brasage basse température sur l'embase **1.**

On a matérialisé par la référence **6** une connexion électrique filaire, émanant du composant **5,** et aboutissant au niveau du cadre inférieur **4** en céramique cofrittée, assurant la traversée du signal électrique vers l'extérieur du boitier au moyen de vias ou de pistes en or.

Dans la seconde forme de réalisation illustrée à la figure 2, l'embase **1** en Kovar^{®} est remplacée par une embase **7** réalisée en céramique cofrittée. Le reste du boîtier demeure sensiblement identique à la forme de réalisation précédente, et ladite embase sert cette fois à assurer la traversée électrique étanche des connexions électriques issues du composant.

Dans ces deux formes de réalisation, la céramique cofrittée, qu'elle soit positionnée en embase ou en cadre périphérique inférieur, remplit à la fois une fonction mécanique, de fixation du capot du boîtier ou de fond du boîtier, et une fonction électrique, à savoir le transfert des connexions issues du composant. Si certes, ces deux technologies sont aujourd'hui largement maîtrisées, et présentent un certain nombre d'avantages, notamment en termes de simplicité et d'efficacité, la brasure mécanique avec un cadre Kovar^{®} permettant d'assurer l'étanchéité recherchée, en revanche, elles présentent un inconvénient majeur, à savoir la limitation en taille du boîtier et donc du ou des composants qu'il est susceptible de renfermer.

En effet, nonobstant la mise en oeuvre de Kovar^{®}, alliage connu pour son faible coefficient de dilatation thermique, les problèmes de dilatation différentielle respectivement de la céramique et de ce matériau subsistent, et s'avèrent rapidement rédhibitoires dès que l'on dépasse des dimensions de 60 millimètres x 60 millimètres pour le boitier étanche. En effet, la dilatation différentielle devient trop importante entre le Kovar^{®} et la céramique lorsque l'on brase les pièces ensemble, typiquement, à une température voisine de 800 °C.

Une autre technologie est également utilisée. Elle consiste à mettre en oeuvre un insert céramique cofrittée, qui là encore assure la fonction de traversée électrique étanche. On a représenté en relation avec les figures 3 et 4 deux modes de réalisation de cette technologie.

Dans la figure 3, l'insert céramique **18** est mis en place au niveau de l'une des parois latérales de l'embase **10** définissant le boîtier en coopération avec le capot supérieur **12.** L'insert est brasé sur ladite paroi latérale.

Dans la figure 4, l'insert **19** est brasé au niveau du fond de l'embase **10** du boîtier.

Quel que soit le mode de réalisation de cette seconde technologie, aucune limitation en termes de taille n'est à déplorer. En revanche, cette technologie présente l'inconvénient d'une relative fragilité de liaison entre l'insert et l'embase. En effet, si par inadvertance on appuie au niveau de l'un des bords de l'insert, on peut le faire basculer par rapport à sa zone d'appui sur la paroi latérale, risquant d'affecter l'étanchéité du boitier en résultant. En outre, on complexifie la mise en oeuvre, puisqu'on a besoin d'une métallisation et d'un brasage sur face et sur tranche de l'insert céramique.

La présente invention vise à s'affranchir de ces différents inconvénients.

### EXPOSE DE L'INVENTION

Elle vise ainsi tout d'abord un procédé pour la réalisation de traversées électriques étanches au travers d'un boîtier d'encapsulation, notamment pour un composant électronique, optique ou optoélectronique.

Ce procédé consiste :
- à ménager un orifice traversant au sein de l'une des parois du boîtier, et avantageusement le fond dudit boîtier ; et
- à braser sur cet orifice, une plaque réalisée en céramique cofrittée au sein de laquelle transitent les connexions électriques, émanant du composant en direction de l'extérieur du boitier.

On conçoit de fait que de par le procédé ainsi mise en oeuvre, la plaque céramique n'assure plus aucune fonction mécanique, son rôle étant dévolu au seul passage de la traversée électrique, outre à l'obturation du boîtier afin d'assurer le vide.

En outre en raison de la brasure de la plaque céramique face contre face, et non pas face contre tranche, on facilite la technique de mise en place, et en outre, on optimise l'étanchéité du boîtier. En effet, la plaque céramique est brasée au niveau de sa périphérie sur une distance correspondant à la périphérie de l'orifice traversant ménagé au fond de l'embase. Typiquement, la brasure intervient sur le pourtour de la plaque en céramique sur une distance de 2 millimètres au maximum.

L'invention vise également un boîtier d'encapsulation d'un composant, notamment électronique, optique ou optoélectronique.

Selon l'invention, ce boîtier est pourvu d'un orifice traversant ménagé au niveau de son fond ou de l'une de ses parois, obturé(e) par une plaque réalisée en céramique cofrittée, brasée au niveau des bords latéraux définissant ledit orifice traversant, ladite plaque assurant la traversée électrique résultant des connexions électriques issues du composant.

L'invention permet ainsi de s'affranchir du problème de limitation de taille des cryostats dues aux dilatations différentielles Kovar^{®}/céramique, et dès lors, de gagner en taille de manière significative, notamment s'agissant du composant. Par voie de conséquence, le cryostat lui-même peut voir sa taille augmenter. De fait, il devient possible d'encapsuler de plus gros composants avec la technologie céramique cofrittée HTCC, et ce, sans mettre en oeuvre les technologies mettant en oeuvre un insert.

En effet, l'orifice ménagé au niveau du fond du boîtier peut être de dimension quelconque puisqu'aussi bien, on dimensionne la plaque céramique cofrittée en fonction des caractéristiques desdites dimensions.

### BREVE DESCRIPTION DES FIGURES

La manière dont l'invention peut être réalisée et les avantages qui en découlent ressortiront mieux de l'exemple de réalisation qui suit, donné à titre indicatif et non limitatif à l'appui des figures annexées.
La figure 1 est, comme déjà dit, une représentation schématique en section transversale d'un boîtier réalisé selon une technologie céramique cofrittée de l'art antérieur.
La figure 2 est une figure analogue de la figure 1 d'un autre mode de réalisation de cette technologie.
La figure 3 est également comme déjà dit une représentation schématique en section transversale d'un boîtier mettant en oeuvre la technologie de l'insert céramique cofrittée de l'art antérieur.
La figure 4 est une représentation schématique d'une variante de la figure 3.
La figure 5 est une représentation schématique en section transversale d'un boîtier conforme à l'invention.

### DESCRIPTION DETAILLEE DE L'INVENTION

On a donc représenté en relation avec la figure 5, une vue schématique en section transversale d'un boîtier conforme à l'invention. L'embase **20** du boîtier est réalisée traditionnellement en Kovar^{®}. Elle est obturée par un capot ou cadre de fermeture **22,** également réalisé en Kovar^{®}, ledit capot étant rapporté par brasure ou par soudure laser sur l'extrémité supérieure libre des parois latérales **21** de l'embase **20.**

Le fond du boîtier reçoit un composant **25,** et par exemple un détecteur infrarouge, fixé à ce niveau par collage ou par brasage basse température.

Selon une caractéristique de l'invention, le fond du boîtier est également percé d'un orifice traversant **31.**

Cet orifice traversant **31** est destiné à être obturé par une plaque **30,** réalisée en céramique cofrittée, type HTCC. Cette plaque **30** est fixée par brasure au niveau du bord latéral **32** définissant l'orifice traversant précité.

La largeur du bord latéral **32** de l'orifice **31** de l'embase définissant le fond, et destiné à coopérer par brasure avec la plaque **30** est déterminée par les technologies standards de brasure céramque / Kovar^{®}.

Cette plaque **30** en céramique cofrittée assure, ainsi qu'on peut l'observer, la traversée électrique des signaux émis par le composant **25,** et éventuellement acheminés à ce niveau au moyen des connexions **26** issues du composant.

On peut ainsi observer tout d'abord que la plaque **30** en céramique n'assure aucune fonction mécanique. Elle assure limitativement l'obturation de l'orifice **31** de l'embase **20** du boîtier pour permettre ainsi la mise sous vide du boîtier, et la traversée électrique.

En raison du principe même mis en oeuvre, on constate également qu'aucune limitation de taille du cryostat n'existe puisqu'aussi bien, on ne se heurte pas à des problèmes de dilatation différentielle, respectivement du matériau constitutif du boîtier (Kovar^{®}) et de la plaque céramique, dans la mesure où cette dernière reste de petite dimension.

La transmission en outre des signaux électriques peut être réalisée sur face avec des pistes en or rapportées sur la plaque céramique, qui traverse sur l'autre face par des vias.

Au demeurant, il convient de souligner que la technique de brasure Kovar^{®} sur céramique est parfaitement maîtrisée, surtout, comme c'est le cas en l'espèce, lorsqu'elle est assurée face sur face, et non pas face sur tranche, optimisant ainsi l'étanchéité du boîtier d'encapsulation et donc la qualité du vide.

On conçoit dès lors tout l'intérêt de la présente invention en raison des perspectives qu'elle donne en termes d'encapsulation de gros composants.

## Revendications

1. Procédé pour la réalisation de traversées électriques étanches au travers d'un boîtier d'encapsulation, notamment pour un composant électronique, optique ou optoélectronique, consistant :
- à ménager un orifice traversant (31) au sein de l'une des parois du boîtier, et avantageusement le fond (20) dudit boîtier ; et
- à braser sur cet orifice, une plaque (30) réalisée en céramique cofrittée au sein de laquelle transitent les connexions électriques.

2. Procédé pour la réalisation de traversées électriques étanches au travers d'un boîtier d'encapsulation selon la revendication 1, ***caractérisé* en ce que** la plaque (30) en céramique cofrittée est brasée sur la paroi, et notamment sur le fond (20) du boitier face contre face.

3. Procédé pour la réalisation de traversées électriques étanches au travers d'un boîtier d'encapsulation selon l'une des revendications 1 et 2, ***caractérisé* en ce que** le boitier est réalisé en alliage de FeNiCo.

4. Boitier d'encapsulation pour au moins un composant électronique, optique ou optoélectronique (25), au sein duquel est susceptible de régner le vide, et constitué d'un fond ou d'une embase (20) sur lequel est rapporté par brasure ou soudure un capot ou cadre de fermeture (22), ***caractérisé* en ce qu'il** est pourvu d'un orifice traversant (31) ménagé au niveau de son fond (20), ledit orifice étant obturé au moyen d'une plaque (30), réalisée en céramique cofrittée, brasée au niveau des bords latéraux (32) définissant ledit orifice traversant, ladite plaque assurant la traversée électrique des signaux générés par ledit composant.
